# FASCICULE DE BREVET EUROPEEN

(11) **EP 2 691 237 B1**
(45) Date de publication et mention de la délivrance du brevet: **22.04.2015**
(21) Numéro de dépôt: 12702260.6
(22) Date de dépôt: 03.02.2012
(51) Int. Cl.: B41F 15/34, B41F 15/36, H05K 3/12

(54) **POCHOIR SERIGRAPHIQUE POUR IMPRESSION SUR UNE CELLULE PHOTOVOLTAÏQUE**
SIEBDRUCKSCHABLONE ZUM DRUCKEN AUF EINER FOTOVOLTAIKZELLE
SILK-SCREEN STENCIL FOR PRINTING ONTO A PHOTOVOLTAIC CELL

(30) Priorité: 29.03.2011 FR 1152581
(43) Date de publication de la demande: 05.02.2014
(73) Titulaire: Commissariat à l'Énergie Atomique et aux Énergies Alternatives, 75015 Paris (FR)
(72) Inventeur: BETTINELLI, Armand, F-38500 Coublevie (FR); BARBIER, Frédéric, F-38400 Saint Martin D'heres (FR)
(74) Mandataire: Novaimo
(86) Numéro de dépôt international: PCT/EP2012/051817
(87) Numéro de publication internationale: WO 2012/130508

(56) Documents cités:
- GB-A- 2 264 460
- GB-A- 2 364 961
- GB-A- 2 385 827

## Description

L'invention concerne un pochoir d'un système d'impression sérigraphique, et un système d'impression en tant que tel comprenant un tel pochoir. Elle est particulièrement adaptée à la fabrication d'un dispositif photovoltaïque, particulièrement à l'impression des conducteurs de collecte sur une cellule photovoltaïque. Elle porte aussi sur un procédé d'impression avec un tel pochoir et un procédé de fabrication d'une cellule photovoltaïque intégrant un tel procédé d'impression. Elle concerne aussi une unité de production de cellules photovoltaïques mettant en oeuvre un tel procédé.

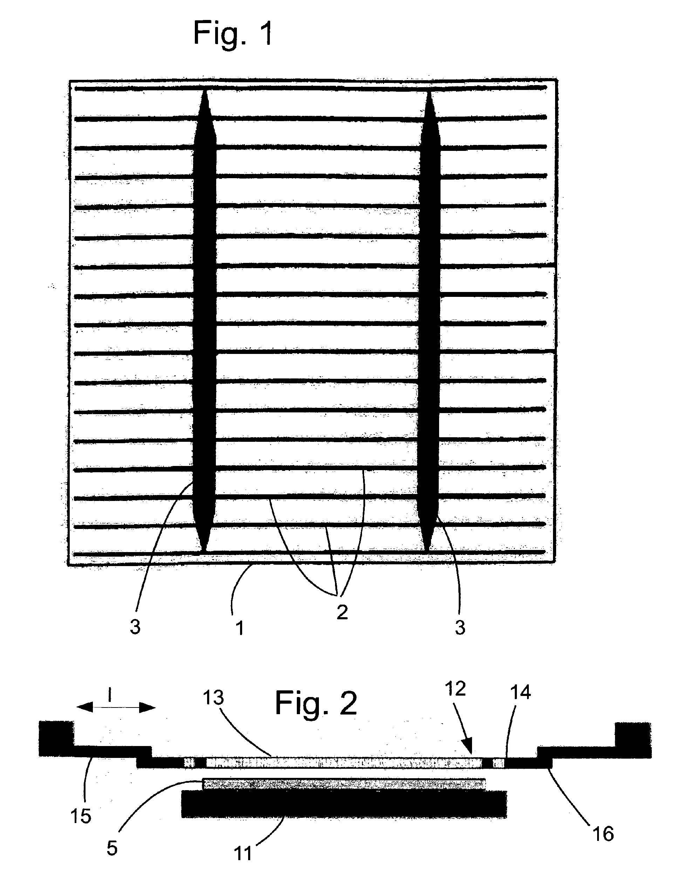

Une cellule photovoltaïque est fabriquée à l'aide d'une plaquette en matériau semi-conducteur, généralement en silicium, connue sous sa dénomination anglaise de « wafer ». Cette fabrication nécessite en particulier la formation de conducteurs électriques sur la surface de cette plaquette. La figure 1 illustre la surface d'une telle plaquette 1 selon l'état de la technique, qui comprend des premiers conducteurs parallèles de fine largeur, appelés conducteurs de collecte 2, dont la fonction est de collecter les électrons créés dans le silicium par la lumière. La surface de la plaque 1 comprend de plus d'autres conducteurs parallèles plus larges 3, parfois appelés « bus barres », orientés dans une direction perpendiculaire aux conducteurs de collecte 2, dont la fonction est de conduire des charges électriques plus élevées, de cellules photovoltaïques en cellules photovoltaïques. Ces conducteurs plus larges 3 sont reliés en général à un ruban métallique s'étendant sur toute leur longueur. Tous ces conducteurs 2, 3 sont obtenus par différentes techniques permettant de former des lignes conductrices continues, s'étendant de manière continue sur toute la longueur et la largeur de la plaque.

Pour réaliser ces conducteurs, une méthode de l'état de la technique consiste par exemple à déposer une encre conductrice par sérigraphie sur la plaquette, avec une ou deux impression(s) sérigraphique(s). Pour cela, la méthode consiste à faire traverser l'encre conductrice à travers un écran constitué d'une toile ou tissu. Cette toile est recouverte d'une couche d'étanchéité, sauf aux endroits où l'encre doit la traverser. Cette traversée est obtenue avec l'aide d'une racle qui presse l'encre à travers la toile : toutefois, les fils de la toile représentent une gêne dans cette opération, et il n'est pas possible d'obtenir une géométrie idéale des conducteurs résultants, notamment en ce qui concerne la régularité de la hauteur de la couche d'encre déposée : cette méthode ne permet pas de former des conducteurs suffisamment performants. En effet, la performance électrique de ces conducteurs est très sensible à leur géométrie, et notamment au ratio épaisseur/largeur, l'épaisseur se mesurant dans la direction verticale perpendiculaire à la plaque 1, et la largeur se mesurant dans la direction horizontale, transversale au conducteur.

Pour pallier à ces inconvénients, une seconde méthode de l'état de la technique consiste à remplacer la toile précédente par un pochoir métallique, ou feuillard métallique, aussi appelé par sa dénomination anglaise de « stencil », dans lequel sont réalisées des ouvertures traversantes. Toutefois, pour ne pas fragiliser ces masques métalliques et obtenir leur comportement optimal lors de l'impression, il n'est pas possible de réaliser des ouvertures de trop grande surface, et notamment pas des ouvertures qui s'étendraient sur toute la longueur ou la largeur du pochoir, et le procédé nécessite généralement au moins deux impressions, à partir de deux masques distincts complémentaires, pour obtenir les différents conducteurs illustrés sur la figure 1. Pour cette raison, ce procédé reste complexe et coûteux. De plus, comme le pochoir métallique n'a pas l'élasticité d'une toile et ne peut pas suffisamment se déformer sous l'effet d'une racle, il est associé à une toile collée en périphérie pour apporter à l'ensemble une élasticité suffisante, selon une construction appelée « trampoline ». Malgré tout, cette seconde méthode présente les inconvénients suivants :
- La toile exerce une tension sur le pochoir métallique qui induit sa déformation autour de ses ouvertures, notamment celles situées sur les bords. Il en résulte des impressions plus larges que souhaité, ce qui conduit à des défauts d'aspect et ce qui diminue la performance de la cellule photovoltaïque ;
- De plus, cette tension de la toile peut même induire une déformation globale plus importante du pochoir métallique, en général très fin, qui induit par exemple une courbure des lignes prévues normalement rectilignes. Les conducteurs initialement prévus sont donc déformés. De plus, il est très difficile de réaliser la superposition précise de la seconde couche d'encre conductrice sur la première, ce qui nuit à la performance de la cellule photovoltaïque.

Le document EP0729189 illustre à titre d'exemple une approche particulière de cette seconde méthode.

Le document GB 2 264 460 illustre un pochoir selon le préambule de la revendication 1.

Ainsi, un objet général de l'invention est de proposer une solution de réalisation d'un conducteur électrique sur une plaque d'un dispositif photovoltaïque qui réduit les inconvénients des solutions de l'état de la technique.

Plus précisément, l'invention cherche à atteindre tout ou partie des objets suivants :

Un premier objet de l'invention est de proposer une solution de réalisation d'un conducteur électrique sur une cellule photovoltaïque permettant l'optimisation de la performance de la cellule photovoltaïque résultante.

Un second objet de l'invention est de proposer une solution de réalisation d'un conducteur électrique sur une cellule photovoltaïque par un procédé à forte productivité, performant et économique.

A cet effet, l'invention repose sur un pochoir pour système d'impression sérigraphique selon la revendication 1.

Les ouvertures de la zone périphérique de déformation peuvent présenter une surface entraînant une propriété de déformation de la zone périphérique de déformation plus importante que celle de la zone centrale d'impression.

L'invention est plus précisément définie par les revendications.

Ces objets, caractéristiques et avantages de la présente invention seront exposés en détail dans la description suivante de modes d'exécution particuliers faits à titre non-limitatif en relation avec les figures jointes parmi lesquelles :
La figure 1 illustre schématiquement les conducteurs à la surface d'une cellule photovoltaïque selon l'état de la technique.
La figure 2 représente schématiquement un système d'impression sérigraphique pour imprimer des conducteurs à la surface d'une cellule photovoltaïque selon l'invention.
La figure 3 représente une vue de dessus d'un pochoir selon un premier mode de réalisation de l'invention.
La figure 4 représente une vue de dessus agrandie de la partie latérale du pochoir selon le premier mode de réalisation de l'invention.
La figure 5 représente une vue de dessus d'un pochoir selon un second mode de réalisation de l'invention.
La figure 6 représente une vue agrandie de la partie latérale du pochoir selon le second mode de réalisation de l'invention.
La figure 7 représente une vue de dessus d'un pochoir selon un troisième mode de réalisation de l'invention.
La figure 8 représente une vue agrandie de la partie latérale du pochoir selon le troisième mode de réalisation de l'invention.
La figure 9 représente une vue de dessus d'un pochoir selon un quatrième mode de réalisation de l'invention.
La figure 10 représente une vue agrandie de la partie latérale du pochoir selon le quatrième mode de réalisation de l'invention.
La figure 11 représente une vue de dessus d'un pochoir selon un cinquième mode de réalisation de l'invention.
La figure 12 représente une vue agrandie de la partie latérale du pochoir selon le cinquième mode de réalisation de l'invention.
La figure 13 représente une vue de dessus d'un pochoir selon un sixième mode de réalisation de l'invention.

La figure 2 représente le principe d'un mode de réalisation de l'invention, appliqué à une étape d'impression sérigraphique de conducteurs à la surface d'une plaquette de silicium 5 pour former des cellules photovoltaïques. Le système d'impression comprend une table d'impression 11 sur laquelle repose la plaquette de silicium 5, un pochoir métallique 12 comprenant une zone centrale d'impression 13 et une zone périphérique de déformation 14. Ce pochoir métallique 12 est associé à une toile 15 fixée par tout dispositif de fixation 16 sur sa périphérie, selon la construction trampoline mentionnée précédemment.

La zone centrale d'impression 13 du pochoir métallique 12 comprend des ouvertures destinées à être traversées par l'encre conductrice pour former les conducteurs à la surface de la plaquette de silicium 5, pour former différents conducteurs des futures cellules photovoltaïques comme cela a été explicité précédemment et représenté par la figure 1. D'autre part, le pochoir 12 comprend une zone périphérique de déformation 14 qui permet d'induire sa déformation volontaire et préférentielle dans cette zone sous l'effet de la tension induite par la racle et du maintien de la toile 15 lors d'une impression, atténuant, voire supprimant totalement, la déformation de la zone centrale d'impression 13 du pochoir, notamment dans sa partie latérale, permettant ainsi d'éviter les inconvénients de l'état de la technique.

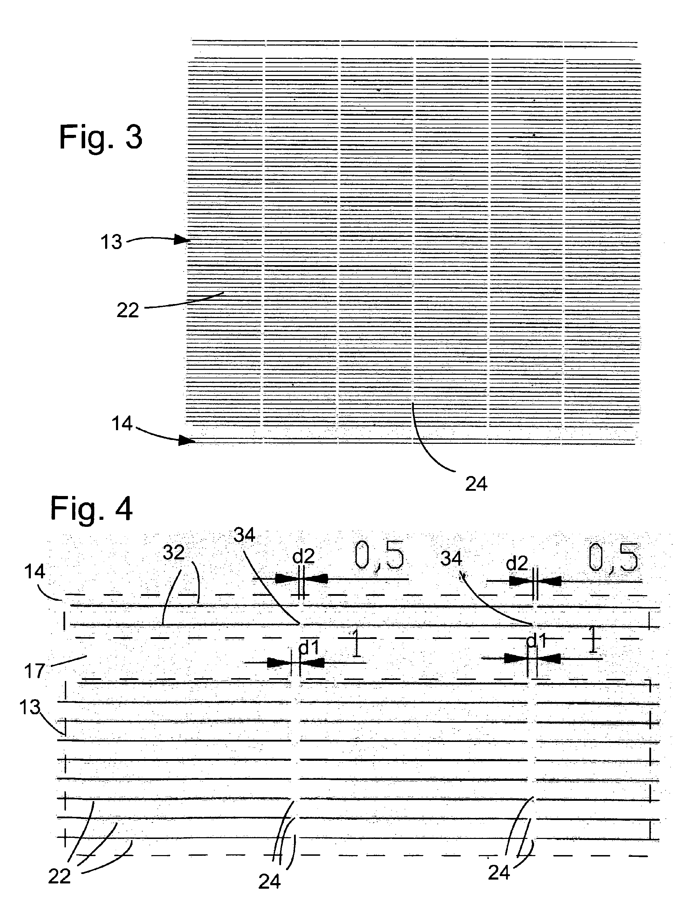

Les figures 3 à 12 représentent des exemples particuliers de pochoirs d'un système d'impression selon différents modes de réalisation de l'invention.

Les figures 3 et 4 montrent ainsi un premier mode de réalisation d'un pochoir. Il comprend une zone centrale d'impression 13 comprenant des premières fentes transversales 22 parallèles destinées à former des conducteurs de collecte sur une cellule photovoltaïque. Ces fentes transversales 22 sont discontinues, interrompues par des ponts 24 de matière pour ne pas trop fragiliser le pochoir. La zone centrale d'impression 13 comprend donc une surface sensiblement égale à celle de la cellule photovoltaïque à imprimer et toutes ses ouvertures 22 sont destinées à la transmission d'encre conductrice.

Le pochoir comprend de plus une zone périphérique de déformation 14, destinée à se trouver au-delà de la surface à imprimer sur la cellule photovoltaïque, entre la zone centrale d'impression 13 et la toile 15 latérale. Elle comprend des ouvertures 32 semblables aux fentes transversales 22 pour les conducteurs de collecte, de même largeur, parallèles, présentant des interruptions par des ponts 34 de matière. Ces ponts 34 sont alignés avec les ponts 24 de la zone centrale d'impression 13. Dans cette réalisation, ces ouvertures 32 sont constituées de deux fentes rectilignes parallèles comprenant quatre segments chacune, séparés par trois ponts 34 chacune. Toutefois, ces ponts 34 présentent une largeur d2 inférieure à celle d1 des ponts 24 de la zone centrale d'impression 13. Dans ce mode de réalisation, d1 = 0.8 mm et d2 = 0.5 mm. Ainsi, les ouvertures 32 présentent une structure plus favorable aux déformations que les fentes transversales 22 de la zone centrale d'impression 13. De plus, comme elles sont localisées sur les parties du pochoir qui subissent le plus fortement les contraintes de la toile 15, leur déformation préférentielle évite la transmission de fortes contraintes vers la zone centrale d'impression 13 et réduit fortement la déformation de cette dernière.

En variante, toute autre géométrie favorisant la déformation périphérique et non centrale du pochoir peut être choisie. Par exemple, les ouvertures 32 pourraient comprendre moins de ponts 34 que le nombre de ponts 24 des fentes transversales 22.

De plus, les ouvertures 32 de la zone périphérique 14 sont fermées par un film d'étanchéité souple pour éviter un éventuel passage d'encre dans cette zone périphérique, non prévue pour une impression.

En remarque, la zone périphérique de déformation 14 est séparée de la zone centrale d'impression 13 par une zone continue 17 qui apporte une stabilité mécanique à l'ensemble du pochoir.

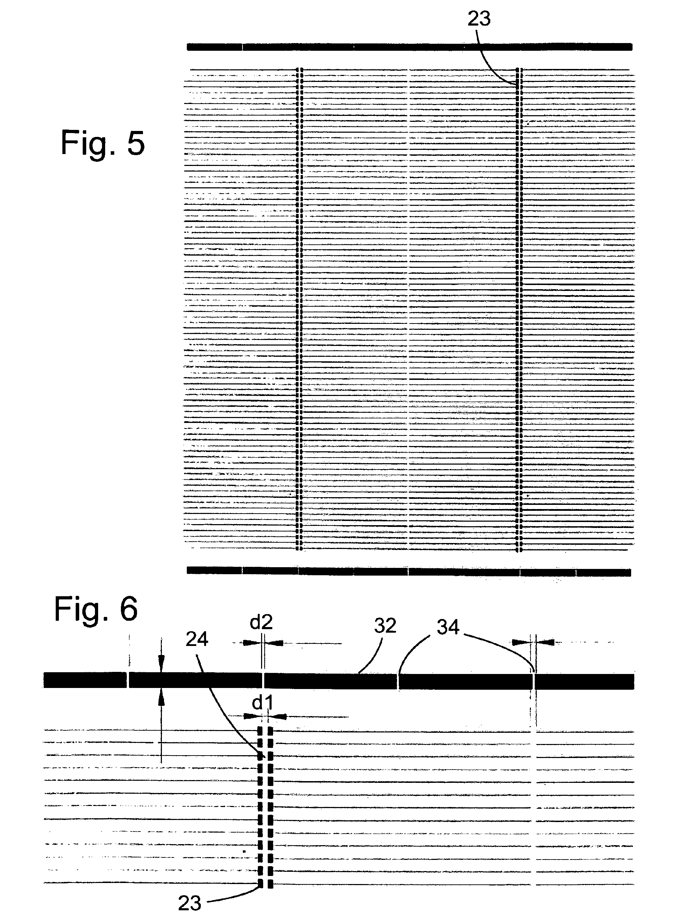

Les figures 5 et 6 illustrent un second mode de réalisation qui diffère du mode de réalisation précédent en ce que les ouvertures 32 de la zone périphérique de déformation 14 sont beaucoup plus larges, toujours séparées par des ponts 34 de largeur d2 toujours inférieure à celle d1 des ponts 24 de la zone centrale d'impression, identique au mode de réalisation précédent. Cette zone centrale d'impression 13 comprend de plus des ouvertures 23 plus larges, discontinues, orientées perpendiculairement aux futurs conducteurs de collecte, destinées à former les deux futurs « bus barres » de la cellule photovoltaïque.

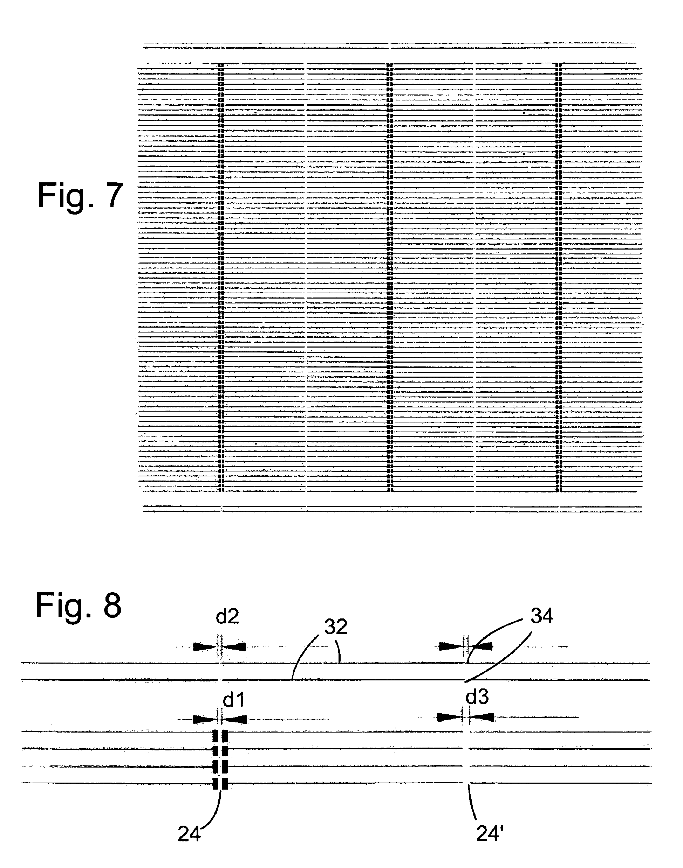

Les figures 7 et 8 illustrent un troisième mode de réalisation d'un pochoir qui diffère des modes de réalisation précédents en ce que la zone centrale d'impression 13 comprend des fentes transversales 22 pour former des conducteurs de collecte, qui sont composées de six segments interrompus par cinq ponts 24. En remarque, dans cette réalisation, les ponts 24 prévus au niveau des ouvertures 23 pour les futurs bus barres sont plus étroits que les autres ponts 24 ' (d1 < d3). Ce pochoir est de plus prévu pour la réalisation de trois bus barres et non deux comme précédemment. La zone périphérique de déformation 14 comprend de même deux ouvertures 32 parallèles aux fentes transversales 22 et interrompues par des ponts 34 de plus petite largeur d2 que les ponts 24, 24' de la zone centrale d'impression 13 (d2 < d1, d2 < d3).

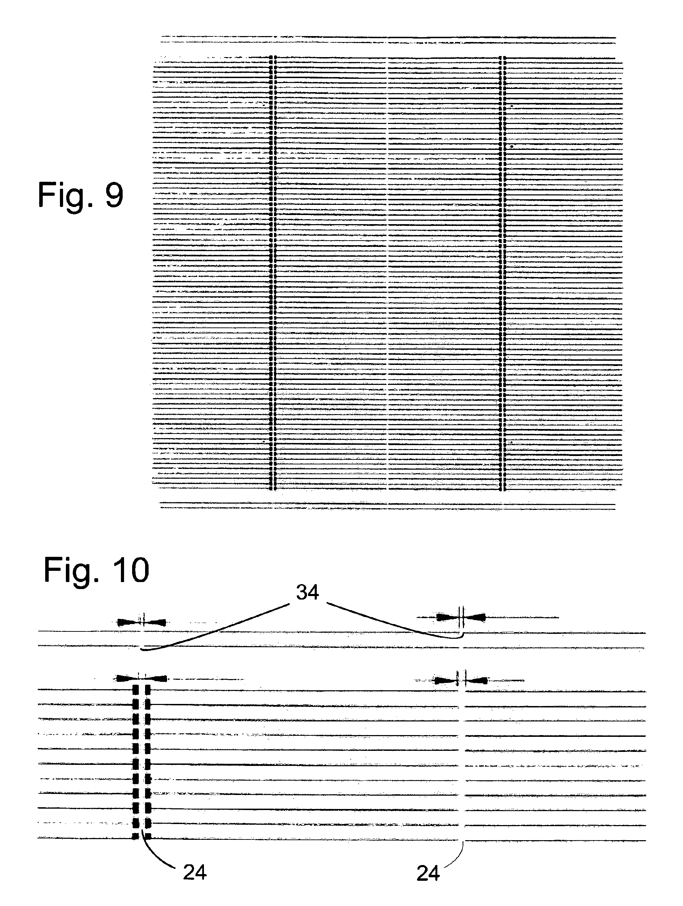

Les figures 9 et 10 illustrent un quatrième mode de réalisation qui diffère du premier mode de réalisation par le fait que les ponts 24 prévus au niveau des ouvertures 23 pour les futurs bus barres sont plus étroits que les autres 24', comme dans le mode de réalisation précédent.

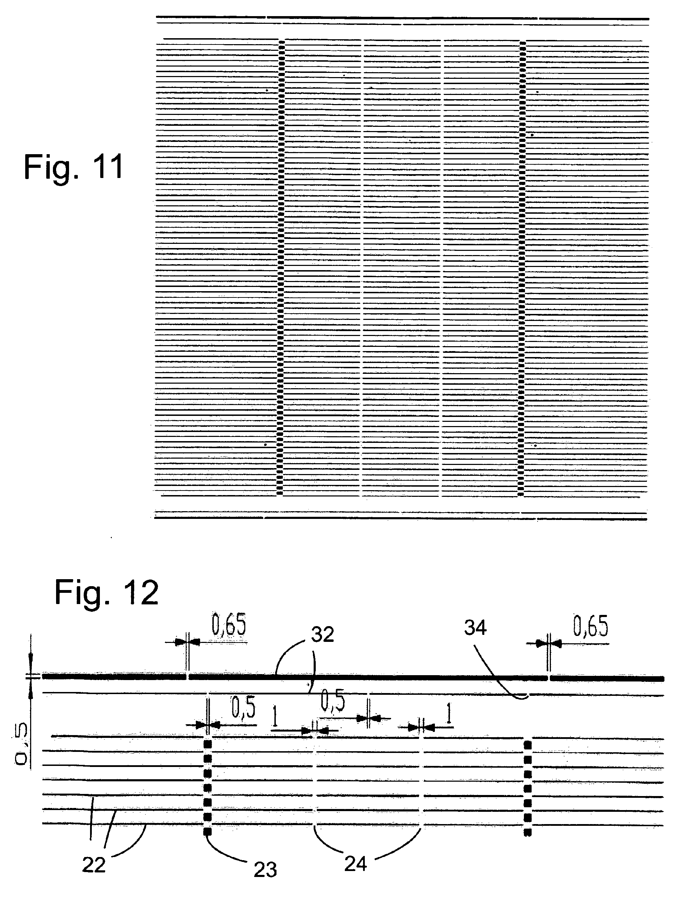

Les figures 11 et 12 illustrent un cinquième mode de réalisation qui diffère des modes de réalisation précédents en ce que les ponts 34 d'interruption des ouvertures 32 situées dans la zone périphérique de déformation 14 ne sont pas tous alignés avec ceux 24 des fentes transversales 22 de la zone centrale d'impression 13. Ces ouvertures 32 situées dans la zone périphérique de déformation 14 présentent des épaisseurs différentes. De plus, dans cette réalisation, les ouvertures 23 prévues pour la création des futurs bus barres présentent une forme légèrement différente, orientée dans une direction parallèle aux fentes 22. Enfin, ce mode de réalisation peut être combiné avec le mode de la figure 4.

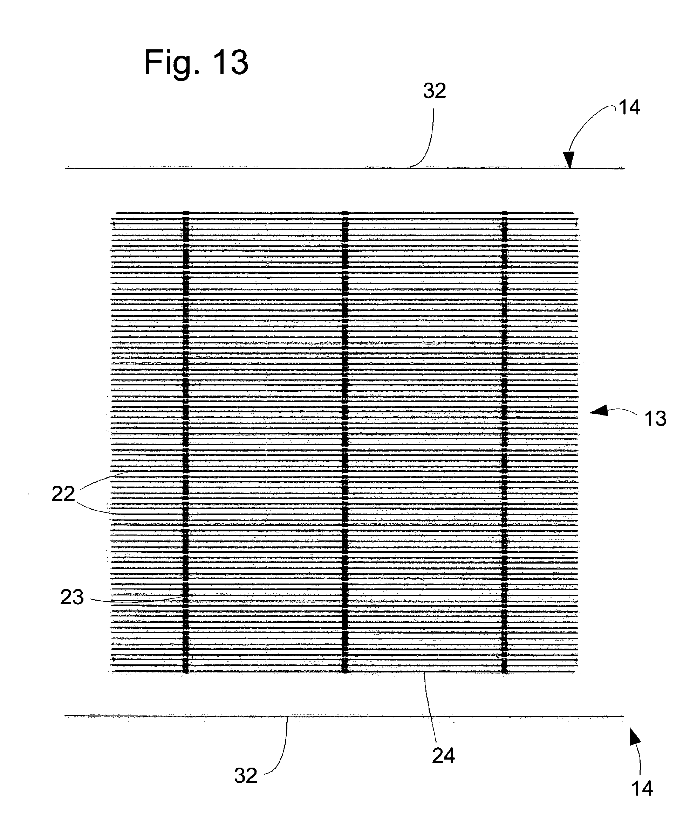

Naturellement, il est possible d'imaginer d'autres réalisations que celles illustrées. Notamment, les ouvertures 32 de la zone périphérique de déformation 14 peuvent prendre d'autres formes et dimensions, non nécessairement rectilignes, et non nécessairement identiques sur un même pochoir. Il existe au moins une ouverture 32 de part et d'autre de la zone centrale d'impression 13. Ces ouvertures sont de préférence symétriquement réparties autour de la zone centrale d'impression 13. Ces ouvertures 32 ont été représentées discontinues mais en variante, elles pourraient être continues, comme cela est illustré en référence avec la figure 13. Dans les modes de réalisation décrits, des ponts 34 de matière de plus petite largeur sont prévus sur la zone périphérique de déformation 14 que ceux 24 de la zone centrale d'impression 13. En variante, ces ponts 34 peuvent présenter une largeur supérieure ou égale mais se trouver en nombre inférieur de sorte que la largeur totale qu'ils représentent sur toute la longueur du pochoir, en additionnant toutes les largeurs de tous les ponts 34, reste inférieure à la largeur totale des ponts 24 de la zone centrale d'impression, obtenue en additionnant toutes les largeurs de tous ces ponts. Il apparaît donc qu'il est avantageux que ces ouvertures 32 de la zone périphérique de déformation 14 présentent globalement une surface plus importante que les ouvertures voisines prévues pour l'impression, de sorte qu'elles se déforment plus facilement que ces dernières, ou autrement dit, offrent une stabilité mécanique inférieure.

La figure 13 illustre un sixième mode de réalisation qui diffère des modes de réalisation précédents en ce que les ouvertures 32 situées dans la zone périphérique de déformation 14 sont constituées par une ouverture rectiligne continue, en forme de fente, non interrompue par des ponts de matière. Une telle fente est prévue de chaque côté de la zone centrale d'impression 13. Cette zone centrale d'impression 13 se présente comme dans le mode de réalisation précédent. Ces ouvertures 32 dans la zone périphérique de déformation 14 présentent une longueur supérieure à celle des ouvertures ou fentes 22 qui s'étendent transversalement sur sensiblement toute la longueur de la zone centrale d'impression 13. En variante, cette longueur est égale à au moins un tiers de la longueur de la zone centrale d'impression, voire au moins la moitié. De plus, selon une autre variante, plusieurs ouvertures continues parallèles peuvent être prévues de chaque côté de la zone centrale d'impression 13. Selon encore une autre variante de réalisation, cette solution peut être combinée avec les réalisations décrites précédemment.

Le pochoir ainsi décrit est particulièrement adapté à une association avec une toile 15, selon une construction de type trampoline, comme illustré sur la figure 2. D'autre part, dans un tel cas, la largeur l de la toile 15, représentée sur la figure 2, est de préférence supérieure ou égale à 30 mm pour atteindre une élasticité globale suffisante. On veillera aussi à maintenir avantageusement une tension inférieure à 25 N sur cette toile, de préférence entre 13 et 17 N inclus. Enfin, il est possible d'utiliser des pochoirs de plus grande épaisseur avec cette solution, et notamment d'atteindre un ratio entre cette épaisseur du pochoir 12 et la largeur minimale des fentes 22, 23 de la zone centrale d'impression 13 supérieur à 1,5, avantageusement de l'ordre de 2.

La solution décrite est particulièrement adaptée à la réalisation de conducteurs à la surface d'une cellule photovoltaïque. Elle est particulièrement adaptée aux conducteurs présentant des formes en H, c'est-à-dire comprenant plusieurs conducteurs différents reliés entre eux et présentant des directions sensiblement perpendiculaires. Elle est compatible avec toutes cellules, notamment les cellules HET sur lesquelles on trouve des métallisations déposées sur un oxyde transparent conducteur souvent imprimées en deux fois, les deux impressions devant être alignées l'une sur l'autre. Elle est compatible aussi avec les cellules à émetteur sélectif pour lesquelles les métallisations doivent être alignées sur des zones actives prédéfinies. Le pochoir décrit peut être utilisé pour toute sorte d'impression sérigraphique, est notamment bien compatible avec la solution décrite dans le document FR2943947.

L'invention porte aussi sur un procédé de réalisation d'un conducteur électrique sur une plaque à l'aide d'un pochoir métallique de type stencil tel que décrit précédemment, caractérisé en ce qu'il comprend l'étape d'impression au travers du pochoir pour déposer une couche d'encre conductrice sur la surface de la plaque, de sorte de former plusieurs conducteurs, à l'aide d'une racle pressant cette encre dans les ouvertures de la partie centrale du pochoir et induisant sa déformation dans une partie périphérique.

Ce procédé d'impression est particulièrement intéressant pour un procédé de fabrication d'un dispositif photovoltaïque, pour former tout ou partie des conducteurs de surface comme les conducteurs de collecte et/ou les conducteurs de type bus barres.

Notamment, l'impression peut permettre de former des premiers conducteurs selon une première direction, ces conducteurs étant discontinus, interrompus au niveau d'au moins une zone d'interconnexion, avant la réalisation d'une liaison électrique en recouvrant les zones d'interconnexion des premiers conducteurs par au moins un second conducteur. Cette dernière étape est avantageusement obtenue par la fixation d'un ruban métallique par soudure ou collage.

## Revendications

1. Pochoir pour système d'impression sérigraphique, comprenant des fentes (22, 23) dans une zone centrale d'impression (13) représentant un motif à imprimer, ledit pochoir comprenant au moins une ouverture (32) dans une zone périphérique de déformation (14), dont au moins une ouverture (32) rectiligne, parallèle à des fentes (22) de la zone centrale d'impression, et disposée sur chacune des deux parties latérales du pochoir **caractérisé en ce que** lesdites parties latérales sont orientées dans la direction de cette fente (22) de la zone centrale d'impression et positionnées de part et d'autre de cette fente (22) de la zone centrale d'impression, l'ouverture (32) en zone périphérique de déformation (14) présentant une surface entraînant une propriété de déformation de la zone périphérique de déformation (14) plus importante que celle de la zone centrale d'impression (13) et destinée à induire des déformations de cette zone périphérique de déformation (14) sous l'effet d'une tension appliquée au pochoir tout en réduisant la déformation de la zone centrale d'impression (13).

2. Pochoir selon la revendication précédente, **caractérisé en ce qu'**il comprend une pluralité de fentes (22) transversales dans la zone centrale d'impression (13), ces fentes (22) étant parallèles, discontinues, interrompues par des ponts (24) de matière, destinées à former des conducteurs de collecte sur une cellule photovoltaïque.

3. Pochoir selon la revendication précédente, **caractérisé en ce que** les ouvertures (32) de la zone périphérique de déformation (14) sont parallèles aux fentes (22) transversales.

4. Pochoir selon l'une des revendications précédentes, **caractérisé en ce qu'**il comprend au moins une ouverture (32) continue sur toute sa longueur dans la zone périphérique de déformation (14), qui présente une longueur supérieure ou égale à un tiers de la longueur de la zone centrale d'impression (13), ou est supérieure ou égale à la moitié de cette longueur, ou est supérieure ou égale à cette longueur.

5. Pochoir selon l'une des revendications précédentes, **caractérisé en ce qu'**il comprend au moins deux ouvertures (32) continues sur toute leur longueur disposées respectivement sur deux côtés opposés autour de la zone centrale d'impression (13) dans la zone périphérique de déformation (14).

6. Pochoir selon l'une des revendications 1 à 3, **caractérisé en ce que** les ouvertures (32) de la zone périphérique de déformation (14) comprennent au moins une ouverture rectiligne discontinue, interrompue par des ponts (34) de matière.

7. Pochoir selon la revendication précédente, **caractérisé en ce que** la zone centrale d'impression (13) comprend des fentes (22) rectilignes interrompues par des ponts (24) de matière, et **en ce que** les ponts (34) de matière d'une ouverture (32) de la zone périphérique de déformation (14) présentent une largeur totale inférieure à la largeur totale de tous les ponts (24) d'une fente (22) de la zone centrale d'impression (13).

8. Pochoir selon la revendication précédente, **caractérisé en ce que** les ouvertures (32) de la zone périphérique de déformation (14) sont parallèles à des fentes (22) de la zone centrale d'impression (13) et **en ce qu'**il comprend le même nombre de ponts (34) sur une ouverture (32) de la zone périphérique de déformation (14) que sur ces fentes (22) de la zone centrale d'impression (13), **en ce que** ces ponts (34) sont alignés avec ceux (24) de ces fentes (22) de la zone centrale d'impression (13) et **en ce que** la largeur des ponts (34) de la zone périphérique de déformation (14) est inférieure à celle des ponts (24) des fentes (22) de la zone centrale d'impression (13).

9. Pochoir selon la revendication 7, **caractérisé en ce que** les ouvertures (32) de la zone périphérique de déformation (14) sont parallèles à des fentes (22) de la zone centrale d'impression (13) et **en ce qu'**il comprend moins de ponts (34) sur une ouverture (32) de la zone périphérique de déformation (14) que sur une fente (22) de la zone centrale d'impression (13).

10. Pochoir selon l'une des revendications précédentes, **caractérisé en ce que** le ratio entre l'épaisseur du pochoir et la largeur minimale des fentes (22) de la zone centrale d'impression (13) est supérieur à 1,5.

11. Pochoir selon l'une des revendications précédentes, **caractérisé en ce que** les ouvertures (32) de la zone périphérique de déformation (14) sont fermées par un élément d'étanchéité élastique pour éviter le passage d'encre par ces ouvertures (32).

12. Système d'impression sérigraphique **caractérisé en ce qu'**il comprend un pochoir (12) selon l'une des revendications précédentes, ou **en ce qu'**il comprend un pochoir (12) selon l'une des revendications précédentes fixé à une toile (15) pour former un ensemble trampoline.

13. Système d'impression sérigraphique selon la revendication 12, **caractérisé en ce qu'**il est une partie d'une unité d'impression de conducteurs sur un dispositif photovoltaïque.

14. Unité de fabrication de dispositifs photovoltaïques, **caractérisée en ce qu'**elle comprend un système d'impression sérigraphique selon l'une des revendications 12 ou 13.

15. Procédé d'impression sérigraphique à partir d'un pochoir selon l'une des revendications 1 à 11, **caractérisé en ce qu'**il comprend une étape de raclage du pochoir induisant une déformation dans la zone périphérique de déformation (14) plus importante que sa déformation dans la zone centrale d'impression (13).

16. Procédé de fabrication d'un dispositif photovoltaïque, **caractérisé en ce qu'**il comprend une étape d'impression sérigraphique de conducteurs sur une plaquette silicium à l'aide d'un pochoir selon l'une des revendications 1 à 11.

## Patentansprüche

1. Schablone für ein Siebdrucksystem, umfassend Schlitze (22, 23) in einer zentralen Druckzone (13), die ein zu druckendes Motiv darstellen, wobei die Schablone mindestens eine Öffnung (32) in einer peripheren Deformationszone (14) umfasst, darunter mindestens eine geradlinige Öffnung (32) parallel zu Schlitzen (22) der zentralen Druckzone, angeordnet auf jedem der beiden Seitenteile der Schablone, **dadurch gekennzeichnet, dass** die Seitenteile in die Richtung dieses Schlitzes (22) der zentralen Druckzone gerichtet und beiderseits dieses Schlitzes (22) der zentralen Druckzone positioniert sind, wobei die Öffnung (32) in der peripheren Deformationszone (14) eine Fläche aufweist, die eine Deformationseigenschaft der peripheren Deformationszone (14) nach sich zieht, die größer als jene der zentralen Druckzone (13) und dazu bestimmt ist, Deformationen dieser peripheren Deformationszone (14) unter der Wirkung einer Spannung, die an die Schablone angelegt wird, hervorzurufen, wobei die Deformation der zentralen Druckzone (13) verringert wird.

2. Schablone nach dem vorhergehenden Anspruch, **dadurch gekennzeichnet, dass** sie eine Vielzahl von Querschlitzen (22) in der zentralen Druckzone (13) umfasst, wobei diese Schlitze (22) parallel, nicht durchgehend, durch Materialbrücken (24) unterbrochen und dazu bestimmt sind, Sammelleiter auf einer Fotovoltaikzelle zu bilden.

3. Schablone nach dem vorhergehenden Anspruch, **dadurch gekennzeichnet, dass** die Öffnungen (32) der peripheren Deformationszone (14) zu den Querschlitzen (22) parallel sind.

4. Schablone nach einem der vorhergehenden Ansprüche **dadurch gekennzeichnet, dass** sie mindestens eine Öffnung (32) umfasst, die auf ihrer gesamten Länge in der peripheren Deformationszone (14) durchgehend ist, die eine Länge größer oder gleich einem Drittel der Länge der zentralen Druckzone (13) aufweist oder größer oder gleich der Hälfte dieser Länge oder größer oder gleich dieser Länge ist.

5. Schablone nach einem der vorhergehenden Ansprüche, **dadurch gekennzeichnet, dass** sie mindestens zwei Öffnungen (32) umfasst, die auf ihrer gesamten Länge durchgehend sind und jeweils auf zwei entgegengesetzt liegenden Seiten um die zentrale Druckzone (13) in der peripheren Deformationszone (14) angeordnet sind.

6. Schablone nach einem der Ansprüche 1 bis 3, **dadurch gekennzeichnet, dass** die Öffnungen (32) der peripheren Deformationszone (14) mindestens eine nicht durchgehende geradlinige Öffnung umfassen, die durch Materialbrücken (34) unterbrochen ist.

7. Schablone nach dem vorhergehenden Anspruch, **dadurch gekennzeichnet, dass** die zentrale Druckzone (13) geradlinige Schlitze (22) umfasst, die durch Materialbrücken (24) unterbrochen sind, und dass die Materialbrücken (34) einer Öffnung (32) der peripheren Deformationszone (14) eine kleinere Gesamtbreite als die Gesamtbreite aller Brücken (24) eines Schlitzes (22) in der zentralen Druckzone (13) aufweisen.

8. Schablone nach dem vorhergehenden Anspruch, **dadurch gekennzeichnet, dass** die Öffnungen (32) der peripheren Deformationszone (14) zu Schlitzen (22) der zentralen Druckzone (13) parallel sind, und dass sie dieselbe Anzahl an Brücken (34) auf einer Öffnung (32) der peripheren Deformationszone (14) wie auf diesen Schlitzen (22) der zentralen Druckzone (13) umfasst, und dass diese Brücken (34) mit jenen (24) dieser Schlitze (22) der zentralen Druckzone (13) ausgerichtet sind, und dass die Breite der Brücken (34) der peripheren Deformationszone (14) kleiner als jene der Brücken (24) der Schlitze (22) der zentralen Druckzone (13) ist.

9. Schablone nach Anspruch 7, **dadurch gekennzeichnet, dass** die Öffnungen (32) der peripheren Deformationszone (14) zu Schlitzen (22) der zentralen Druckzone (13) parallel sind, und dass sie weniger Brücken (34) auf einer Öffnung (32) der peripheren Deformationszone (14) als auf einem Schlitz (22) der zentralen Druckzone (13) umfasst.

10. Schablone nach einem der vorhergehenden Ansprüche, **dadurch gekennzeichnet, dass** das Verhältnis zwischen der Dicke der Schablone und der Mindestbreite der Schlitze (22) der zentralen Druckzone (13) größer als 1,5 ist.

11. Schablone nach einem der vorhergehenden Ansprüche, **dadurch gekennzeichnet, dass** die Öffnungen (32) der peripheren Deformationszone (14) durch ein elastisches Abdichtungselement geschlossen sind, um den Durchgang von Tinte durch diese Öffnungen (32) zu vermeiden.

12. Siebdrucksystem, **dadurch gekennzeichnet, dass** es eine Schablone (12) nach einem der vorhergehenden Ansprüche umfasst, oder dass es eine Schablone (12) nach einem der vorhergehenden Ansprüche, die an einem Tuch (15) befestigt ist, um eine Trampolineinheit zu bilden, umfasst.

13. Siebdrucksystem nach Anspruch 12, **dadurch gekennzeichnet, dass** es ein Teil einer Leiterdruckeinheit auf eine Fotovoltaikvorrichtung ist.

14. Einheit zur Herstellung von Fotovoltaikvorrichtungen, **dadurch gekennzeichnet, dass** sie ein Siebdrucksystem nach einem der Ansprüche 12 oder 13 umfasst.

15. Siebdruckverfahren auf Basis einer Schablone nach einem der Ansprüche 1 bis 11, **dadurch gekennzeichnet, dass** es einen Schritt des Abziehens der Schablone umfasst, der zu einer Deformation in der peripheren Deformationszone (14) führt, die stärker als ihre Deformation in der zentralen Druckzone (13) ist.

16. Verfahren zur Herstellung einer Fotovoltaikvorrichtung, **dadurch gekennzeichnet, dass** es einen Schritt des Siebdrucks von Leitern auf eine Siliziumplatte mit Hilfe einer Schablone nach einem der Ansprüche 1 bis 11 umfasst.

## Claims

1. Stencil for a screen-printing system, comprising slits (22, 23) in a central printing zone (13), forming a pattern to be printed, said stencil comprising, in a peripheral deforming zone (14), at least one aperture (32) including at least one rectilinear aperture (32) lying parallel to slits (22) in the central printing zone, which at least one rectilinear aperture (32) is placed in each of the two lateral parts of the stencil, **characterized in that** said lateral parts are oriented in the direction of this slit (22) in the central printing zone and positioned on either side of this slit (22) in the central printing zone, the aperture (32) in the peripheral deforming zone (14) having an area leading the peripheral deforming zone (14) to have a greater tendency to deform than the central printing zone (13), and being intended to cause this peripheral deforming zone (14) to deform under the effect of a stress applied to the stencil while reducing deformation of the central printing zone (13).

2. Stencil according to the preceding claim, **characterized in that** it comprises a plurality of transverse slits (22) in the central printing zone (13), these slits (22) being parallel, discontinuous, interrupted by bridges (24) of material, and intended to form collecting conductors on a photovoltaic cell.

3. Stencil according to the preceding claim, **characterized in that** the apertures (32) in the peripheral deforming zone (14) lie parallel to the transverse slits (22).

4. Stencil according to one of the preceding claims, **characterized in that** it comprises at least one aperture (32) that is continuous over its entire length in the peripheral deforming zone (14), which aperture has a length larger than or equal to a third of the length of the central printing zone (13), or larger than or equal to half this length, or larger than or equal to this length.

5. Stencil according to one of the preceding claims, **characterized in that** it comprises at least two apertures (32) that are continuous over their entire length, these apertures (32) being placed, respectively, on two opposite sides around the central printing zone (13) in the peripheral deforming zone (14).

6. Stencil according to one of Claims 1 to 3, **characterized in that** the apertures (32) in the peripheral deforming zone (14) comprise at least one discontinuous rectilinear aperture interrupted by bridges (34) of material.

7. Stencil according to the preceding claim, **characterized in that** the central printing zone (13) comprises rectilinear slits (22) interrupted by bridges (24) of material, and **in that** the bridges (34) of material of an aperture (32) in the peripheral deforming zone (14) have a total width smaller than the total width of all the bridges (24) of a slit (22) in the central printing zone (13).

8. Stencil according to the preceding claim, **characterized in that** the apertures (32) in the peripheral deforming zone (14) lie parallel to the slits (22) in the central printing zone (13), **in that** an aperture (32) in the peripheral deforming zone (14) comprises the same number of bridges (34) as these slits (22) in the central printing zone (13), **in that** these bridges (34) are aligned with those (24) of these slits (22) in the central printing zone (13), and **in that** the width of the bridges (34) in the peripheral deforming zone (14) is smaller than that of the bridges (24) of the slits (22) in the central printing zone (13).

9. Stencil according to Claim 7, **characterized in that** the apertures (32) in the peripheral deforming zone (14) lie parallel to the slits (22) in the central printing zone (13), and **in that** one aperture (32) in the peripheral deforming zone (14) comprises fewer bridges (34) than a slit (22) in the central printing zone (13).

10. Stencil according to one of the preceding claims, **characterized in that** the ratio of the thickness of the stencil to the minimum width of the slits (22) in the central printing zone (13) is greater than 1.5.

11. Stencil according to one of the preceding claims, **characterized in that** the apertures (32) in the peripheral deforming zone (14) are closed by an elastic sealing element in order to prevent ink from passing through these apertures (32).

12. Screen-printing system, **characterized in that** it comprises a stencil (12) according to one of the preceding claims or **in that** it comprises a stencil (12) according to one of the preceding claims fastened to a cloth (15) in order to form a trampoline assembly.

13. Screen-printing system according to Claim 12, **characterized in that** it is part of a unit for printing conductors onto a photovoltaic device.

14. Unit for manufacturing photovoltaic devices, **characterized in that** it comprises a screen-printing system according to one of Claims 12 or 13.

15. Screen-printing process using a stencil according to one of Claims 1 to 11, **characterized in that** it comprises a step of doctoring the stencil inducing a deformation in the peripheral deforming zone (14) greater than its deformation in the central printing zone (13).

16. Process for manufacturing a photovoltaic device, **characterized in that** it comprises a step of screen printing conductors onto a silicon wafer using a stencil according to one of Claims 1 to 11.
